(19) Europäisches Patentamt

European Patent Office

Office européen des brevets

(11) **EP 2 063 538 A1**

(12) **EUROPEAN PATENT APPLICATION**

(43) Date of publication:
**27.05.2009 Bulletin 2009/22**

(51) Int Cl.:
**H03M 13/27** (2006.01)

(21) Application number: **07022488.6**

(22) Date of filing: **20.11.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **Panasonic Corporation**
**Kadoma-shi**
**Osaka 571-8501 (JP)**

(72) Inventor: **Petrov, Mihail**
**63225 Langen (DE)**

(74) Representative: **Grünecker, Kinkeldey,**
**Stockmair & Schwanhäusser**
**Anwaltssozietät**
**Leopoldstrasse 4**
**80802 München (DE)**

(54) **Block interleaving of variable-bit-rate data streams**

(57)    The present invention relates to interleaving of transmit data in a frame-based communication system employing a plurality of frequency channels, wherein odd and even frames are interleaved according to a predefined permutation and its inverse permutation, respectively. The present invention provides specific permutations guaranteeing that diversity across the frequency channels is maximum both for odd and even frames. To this end, certain constraints to the number of words per forward error correction block, the maximum number of forward error correction blocks per frame, and the number of frequency channels are identified. According to a particularly advantageous embodiment of the present invention, the permutation is self-inverse, so that odd and even frames are interleaved by a common interleaving scheme.

## Fig. 6

Direct (odd) permutation = Inverse (even) permutation

EP55313

EP 2 063 538 A1

**Description**

The present invention relates to interleaving of transmit data in a frame-based communication system employing a plurality of frequency channels.

BACKGROUND OF THE INVENTION

The invention relates to communication systems, specifically to orthogonal frequency-division multiplexing (OFDM) systems such as the new DVB-T2 standard (DVB-T is short for Digital Video Broadcasting - Terrestrial), where a constant-capacity channel carries multiple variable-data-rate services. The OFDM signal is divided into frames of constant duration, which contain a fixed number of OFDM cells. An OFDM cell is defined as the complex data carried on a certain subcarrier for a given OFDM symbol.

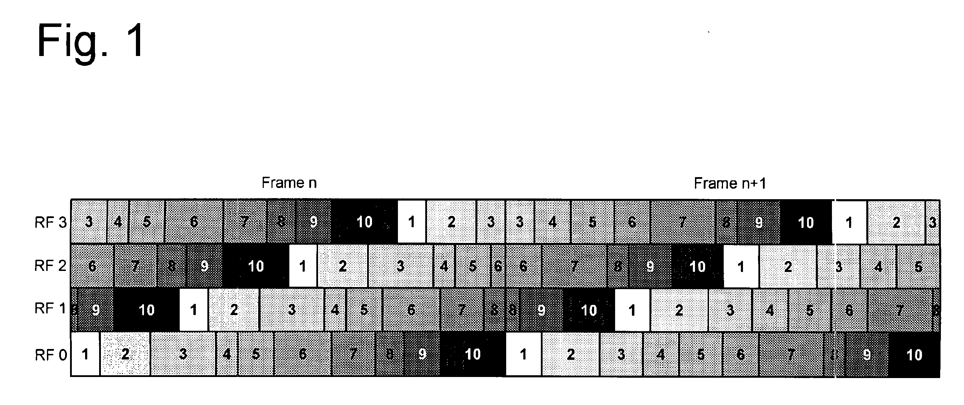

The envisaged system uses a plurality of radio frequency (RF) channels for transmitting a plurality of variable-bit-rate services. Normally, the number of services is larger than the number of RF channels. The services are multiplexed onto an OFDM using time-frequency slicing (TFS). Figure 1 shows two OFDM frames of a TFS example for 4 RF channels and 10 services.

The main idea is that a certain number variable-rate services are mapped on a constant-capacity channel. The more RF channels are available, the larger the overall channel capacity. As the allocation unit is one OFDM frame, the sizes and positions of the slices will typically change on a frame-by-frame basis, following the data-rate variations of the individual services. Of course, the system design must guarantee that for any frame, the number of OFDM cells for all services does not exceed the channel capacity, expressed in terms of OFDM cells per frame.

In OFDM, the channel transfer function changes along both the subcarrier and the symbol axis. This phenomenon is referred to as frequency/time diversity. Besides, in the case of multiple RF channels with time-frequency slicing, some RF channels may be worse than others, which we refer to as macro RF diversity. In order to ensure maximum diversity, data must be spread as evenly as possible over the whole frame. This ensures that a transient error or a deep fading in the two-dimensional channel transfer function will also be spread as evenly as possible over the whole frame. The spreading of data over the whole frame is achieved by using interleaving. The interleaving process is performed separately for each service, before slicing and mapping onto the OFDM frame. For maximum performance, the interleaving should be performed over the whole frame (all slices).

The data stream for each service consists of a sequence of FEC (forward error correction) blocks. The size of an FEC block is constant for a given service. The FEC block may consists of a number of bits, groups of bits, or complex (real+imag) data cells. In DVB-T2, interleaving is performed after complex constellation mapping, so an FEC block consists of complex data cells. In the following, the term "words" is employed to cover all cases, including bits, cells, etc.

The frame duration and the FEC block size are constant. Moreover, only an integer number of FEC blocks per service are allowed in each frame, i.e. there is no fragmentation of the FEC blocks at the frame boundaries. Since the data rate is variable, it follows that the number of FEC blocks per frame is also variable, following the rate variations of the service data over a period of one frame.

In order to have maximum diversity, the words of each FEC blocks must be spread as evenly as possible over the whole frame. Of particular importance is that each FEC block must be evenly spreaded over all RF channels in the TFS structure, i.e. each RF channel must contain the same number of words from each FEC block, which ensures that the macro RF diversity is optimally exploited. Macro RF diversity occurs when the reception quality is not the same on all RF channels in the TFS group, which is the most likely situation in real-life conditions.

The interleaver must therefore fulfill the following conditions. First, it must deal with a variable number of FEC blocks per frame. Second, the words of each FEC block must be evenly distributed over all RF channels. Third, within each channel, the words from each FEC block must be also evenly distributed over time.

Conventional interleavers realize a re-ordering of data items to different frequency channels by writing the data items into memory in one order and reading them from memory in another order. A straightforward implementation of such a block interleaver would require a temporary storage covering two blocks of data.

An improved conventional block interleaver/deinterleaver that requires only one block of memory is known from US patent no. 5,799,033. According to this reference, the memory locations vacated upon reading data items for the modulation signal of one frame are filled by data items of the next successive frame. This is kept up by permuting the order of the memory locations in which the data items are read and written for each successive frame.

Specifically, a predefined address sequence is employed to read data of frame n and to write frame (n+1). Then, the predefined address sequence is replaced by another sequence, for instance by the regular addressing sequence, and frame (n+2) is written while frame (n+1) is read. Since the predefined address sequence is employed once for reading and once for writing, two successive frames are interleaved by means of the permutation defined by the predefined address sequence and the inverse of this permutation, respectively. Note that the inverse of a permutation $p$ is a permutation $p^{-1}$ that satisfies $p^{-1}(p(i))=i$ for all indices $i$.

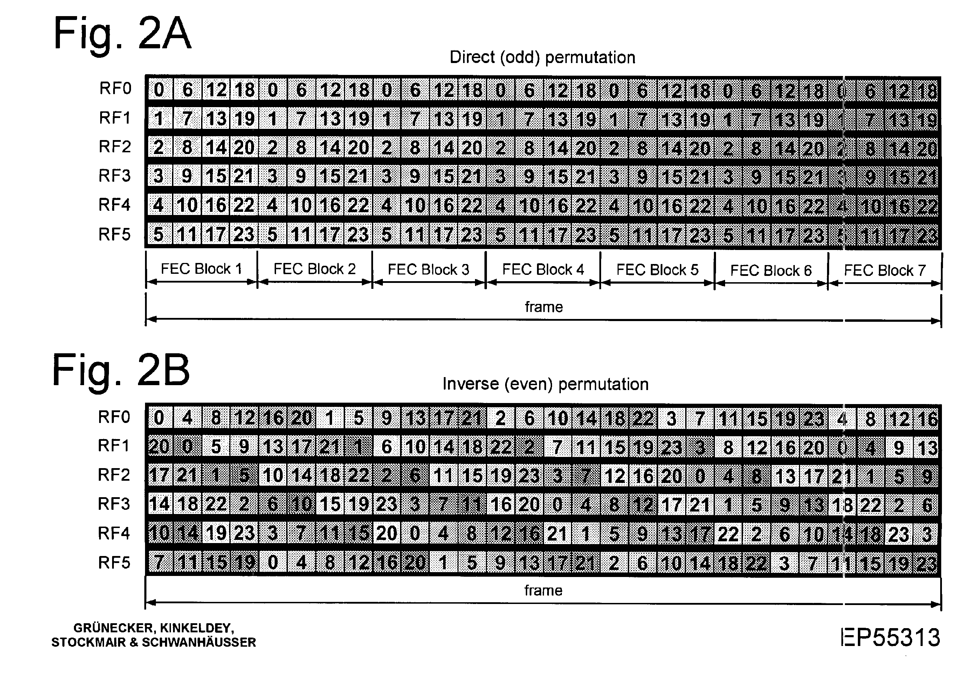

Figure 2 illustrates a straightforward approach to permute data words of, say, an odd frame by writing the FEC words on columns and reading them on rows, where the number of rows is equal to the number of RF channels. Figure 2A shows the resulting interleaving pattern for 7 FEC blocks, each consisting of 24 words, and for 6 RF channels. Each row is sent to one RF channel. As shown in the table below, the words of each FEC blocks are evenly distributed over all six RF channels. Each column corresponds to an FEC block, the figures indicating the number of words allocated to the corresponding RF channel.

Table 1: Number of words of each FEC block mapped to a certain RF channel according to the permutation of Fig. 2A

| Block: | 0 | 1 | 2 | 3 | 4 | 5 | 6 |
|---|---|---|---|---|---|---|---|
| RF0: | 4 | 4 | 4 | 4 | 4 | 4 | 4 |
| RF1: | 4 | 4 | 4 | 4 | 4 | 4 | 4 |
| RF2: | 4 | 4 | 4 | 4 | 4 | 4 | 4 |
| RF3: | 4 | 4 | 4 | 4 | 4 | 4 | 4 |
| RF4: | 4 | 4 | 4 | 4 | 4 | 4 | 4 |
| RF5: | 4 | 4 | 4 | 4 | 4 | 4 | 4 |

The direct permutation thus ensures that each FEC block is evenly distributed over all RF channels, viz. that four words of each FEC block a transmitted via a particular RF channel. However, within each channel, all cells of an FEC block are grouped together, which limits the (time) diversity within that RF channel.

An even bigger problem, however, is the resulting inverse permutation, shown in Figure 2B. It can be seen that the FEC blocks are no longer evenly distributed over all RF channels. Instead of having exactly 24/6 = 4 words in each RF channel, the distribution shown below results. Each column corresponds to an FEC block. In this particular case the distribution is extremely uneven. Some FEC blocks, e.g. block 0 and 6, do not even have words in all RF channels.

Table 2: Number of words of each FEC block mapped to a certain RF channel according to the permutation of Fig. 2B

| Block: | 0 | 1 | 2 | 3 | 4 | 5 | 6 |
|---|---|---|---|---|---|---|---|
| RF0: | 5 | 5 | 5 | 5 | 4 | 4 | 0 |
| RF1: | 5 | 5 | 4 | 4 | 4 | 1 | 5 |
| RF2: | 4 | 4 | 5 | 3 | 2 | 5 | 5 |
| RF3: | 5 | 5 | 2 | 3 | 5 | 4 | 4 |
| RF4: | 5 | 1 | 4 | 4 | 4 | 5 | 5 |
| RF5: | 0 | 4 | 4 | 5 | 5 | 5 | 5 |

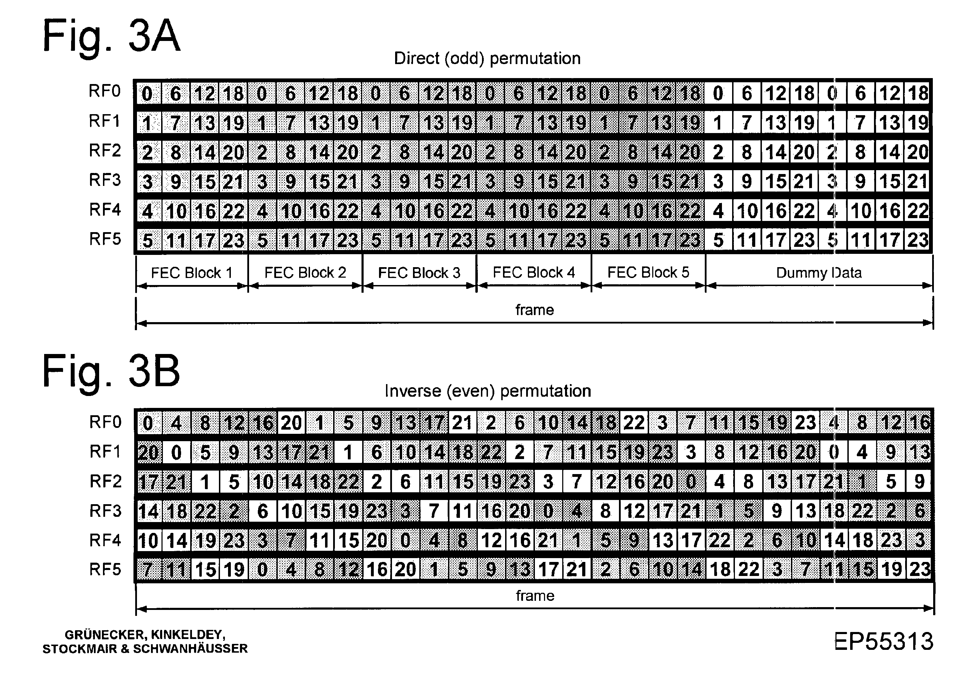

The straightforward approach also supports variable bit rates, as shown in Figure 3A and Figure 3B for the direct and the inverse permutation, respectively. The idea is to add dummy FEC blocks in order to fill up the entire interleaver block. For the direct permutation, it is easy to determine which output words are dummy. However, the same is no longer that easy for the inverse permutation, which complicates the implementation.

SUMMARY OF THE INVENTION

The aim of the present invention is to provide an improved method for data transmission in a frame-based communication system employing a plurality of frequency channels and a corresponding apparatus.

This is achieved by the features as set forth in the independent claims.

Preferred embodiments are the subject matter of dependent claims. It is the particular approach of the present invention to interleave words of odd and even frames by means of a predefined permutation and its inverse permutation, respectively, wherein the predefined permutation and its inverse permutation distribute words of each error correction block of odd and even frames, respectively, equally over the frequency channels.

According to a first aspect of the present invention, a method for data transmission in a frame-based communication system employing a plurality of frequency channels, each frame of transmit data consisting of a plurality of error correction blocks, each error correction block consisting of a plurality of words, each word of a frame being allocated to one of the plurality of frequency channels for transmission, is provided. The method comprises the steps of interleaving the transmit data by applying a predefined permutation to the words of odd frames and by applying the inverse of the predefined permutation to the words of even frames, and is characterized in that said predefined permutation and its inverse permutation are distributing the words of each error correction block of odd and even frames, respectively, equally over the frequency channels.

According to a further aspect of the present invention, a frame-based communication system employing a plurality of frequency channels, each frame of transmit data consisting of a plurality of error correction blocks, each error correction block consisting of a plurality of words, each word of a frame being allocated to one of the plurality of frequency channels for transmission, is provided. Said communication system comprises an interleaver for interleaving the transmit data by applying a predefined permutation to the words of odd frames and by applying the inverse of the predefined permutation to the words of even frames, and is characterized in that said predefined permutation and its inverse permutation are distributing the words of each error correction block of odd and even frames, respectively, equally over the frequency channels.

Preferably, each frequency channel transmits the same number of words of each error correction block of a frame. Further, the number of words of a certain error correction block allocated to a frequency channel is preferably equal for all frequency channels. Further, the number of words of an error correction block allocated to a certain frequency channel is preferably equal for all error correction blocks. In this manner, diversity over the plurality of frequency channels is maximized, reducing the adverse effects of burst errors on error correction.

Preferably, the predefined permutation and its inverse permutation are distributing the words of each error correction block of odd and even frames, respectively, evenly over the frame. In this manner, diversity over time is maximized, reducing the adverse effects of burst errors on error correction.

Preferably, the number of words in an error correction block is an integer multiple of the number of frequency channels. In this manner, the words of each error correction block may be evenly distributed over all frequency channels.

Preferably, a maximum number of error correction blocks per frame is an integer multiple of the number of frequency channels. Further, the number of words in an error correction block is preferably an integer multiple of the maximum number of error correction blocks per frame. In this case, the inverse permutation may likewise distribute all words of each error correction block evenly over all frequency channels.

Preferably, each frame consists of a plurality of columns, each column consisting of a predefined number of consecutive words of an error correction block, said predefined number being equal to the the maximum number of error correction blocks per frame. Further, each column of a frame preferably consists of a plurality of clusters, each cluster consisting of a predefined number of consecutive words of an error correction block, said predefined number being equal to the ratio of the maximum number of error correction blocks per frame and the number of frequency channels, each cluster of said plurality of clusters being allocated to a distinct frequency channel of the plurality of frequency channels. Further, the clusters of each frame are preferably allocated to the plurality of frequency channels in a cyclic manner. In this manner, the permutation and its inverse guarantee that all words of each error correction block evenly over all frequency channels.

Preferably, the predefined permutation and inverse permutation are identical. In this case, hardware and software implementation of the interleaver and deinterleaver will be greatly simplified.

The above and other objects and features of the present invention will become more apparent from the following description and preferred embodiments given in conjunction with the accompanying drawings, in which:

Fig. 1     is a schematic drawing illustrating multiplexing of service data onto an OFDM frame using time-frequency slicing (TFS);

Fig. 2A     is a schematic drawing illustrating interleaving of odd-frame transmit data according to a conventional approach;

Fig. 2B     is a schematic drawing illustrating interleaving of even-frame transmit data according to a conventional approach employing the inverse permutation of Fig. 2A;

Fig. 3A     is a schematic drawing illustrating interleaving of odd-frame transmit data with variable bit rate according to a conventional approach;

Fig. 3B     is a schematic drawing illustrating interleaving of even-frame transmit data with variable bit rate according to a conventional approach employing the inverse permutation of Fig. 3A;

Fig. 4     is a schematic drawing illustrating interleaving of odd-frame transmit data according to the first embodiment of the present invention;

Fig. 5    is a schematic drawing illustrating interleaving of even-frame transmit data according to the first embodiment of the present invention employing the inverse permutation of Fig. 4;

Fig. 6    is a schematic drawing illustrating interleaving of odd-frame and even-frame transmit data according to the second embodiment of the present invention;

Fig. 7    is a schematic drawing illustrating interleaving of odd-frame and even-frame transmit data with variable bit-rate according to the third embodiment of the present invention;

Fig. 8    is a further example illustrating interleaving of odd-frame transmit data according to the first embodiment of the present invention;

Fig. 9    is a further example illustrating interleaving of even-frame transmit data according to the first embodiment of the present invention employing the inverse permutation of Fig. 8;

Fig. 10    is a further example illustrating interleaving of odd-frame and even-frame transmit data according to the second embodiment of the present invention;

Fig. 11    is a further example illustrating interleaving of odd-frame and even-frame transmit data with variable bit-rate according to the third embodiment of the present invention;

DETAILED DESCRIPTION

It is the particular approach of the present invention to adapt the permutation employed for interleaving odd frames so that the requirements regarding an even distribution of FEC words over frequency channels are both fulfilled for the permutation and its inverse.

The system under consideration is characterized by three parameters, viz. the number of RF channels $N_{RF}$, the number of words per FEC block $S_{FEC}$, and the maximum number of FEC blocks per frame $N_{FEC}$.

The present invention identifies specific constraints to these parameters, which must be fulfilled so that both the direct and the inverse permutations ensure an even distribution of the FEC blocks over all RF channels.

Specifically, the number of words per FEC block $S_{FEC}$ must be a (integer) multiple of the number of RF channels $N_{RF}$. Otherwise, the words of a FEC block can not be evenly distributed over the RF channels.

Further, the maximum number of FEC blocks per frame $N_{FEC}$ must be a (integer) multiple of the number of RF channels $N_{RF}$ and the number of words per FEC block $S_{FEC}$ must by a (integer) multiple of the maximum number of FEC blocks per frame $N_{FEC}$. These constraints can also be expressed as

$$N_{FEC} = n \cdot N_{RF} \qquad\qquad (1)$$

and

$$S_{FEC} = m \cdot N_{FEC} , \qquad\qquad (2)$$

with m and n being positive integers.

With these parameters, a permutation is defined by writing the frame data to a the columns of table having $N_{RoW} = N_{FEC} = n \cdot N_{RF}$ rows and $N_{COL} = S_{FEC} = m \cdot n \cdot N_{RF}$ columns, and reading the frame data row-by-row. The words of the frame data are then allocated to the frequency channels such that $n = N_{FEC}/N_{RF}$ adjacent rows of this table are allocated to the same channel.

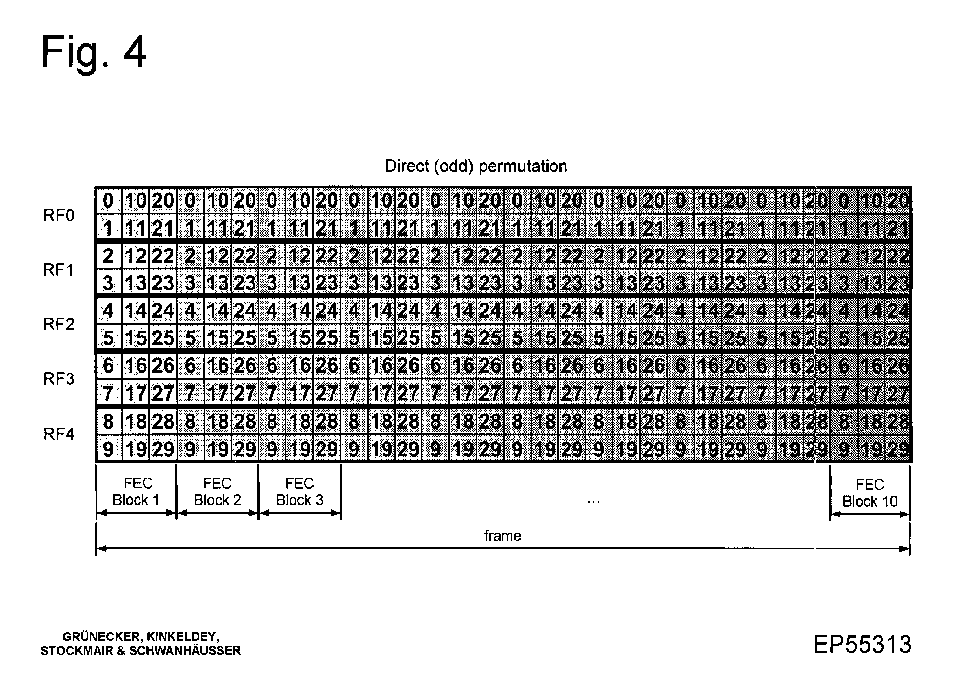

Figure 4 is a schematic drawing illustrating an exemplary interleaving scheme for odd-frame transmit data according to a first embodiment of the present invention. In this example, a frame is made up of a total of ten FEC blocks ($N_{FEC}$=10) with 30 words each ($S_{FEC}$=30). The frame data is allocated to five RF channels ($N_{RF}$=5, RF0,...,RF4). Interleaving is performed by applying the permutation and RF channel allocation indicated in Fig. 4. Specifically, the words of the FEC blocks are consecutively written (top to bottom, left to right) to the columns of a matrix having $N_{COL} = S_{FEC}$=30 columns and $N_{ROW} = N_{FEC}$=10 rows. In this matrix, each $n = N_{FEC}/N_{RF}$=2 adjacent rows are allocated to one of the RF channels RF0, RF1, ..., RF4. The sequence in which the data words are transmitted via any one of these channels is then determined by reading the corresponding rows from left to right, top to bottom.

It is to be noted that the parameter values employed in this example satisfy the above mentioned constraints. Specifically, the number of words per FEC block $S_{FEC}$ is an integer multiple of the number of RF channels $N_{RF}$. Further, the maximum number of FEC blocks per frame $N_{FEC}$ is an integer multiple of the number of RF channels $N_{RF}$ and the number of words per FEC block $S_{FEC}$ is an integer multiple of the maximum number of FEC blocks per frame $N_{FEC}$.

Obviously, the present invention is not restricted to the particular parameter values that are employed in figures and examples of this description merely for illustrative purpose. In fact, smaller or larger values of the number of RF channels $N_{RF}$, the number of words per FEC block $S_{FEC}$, and the maximum number of FEC blocks per frame $N_{FEC}$ may be adopted, as long as the above constraints regarding ratios between these parameters are met.

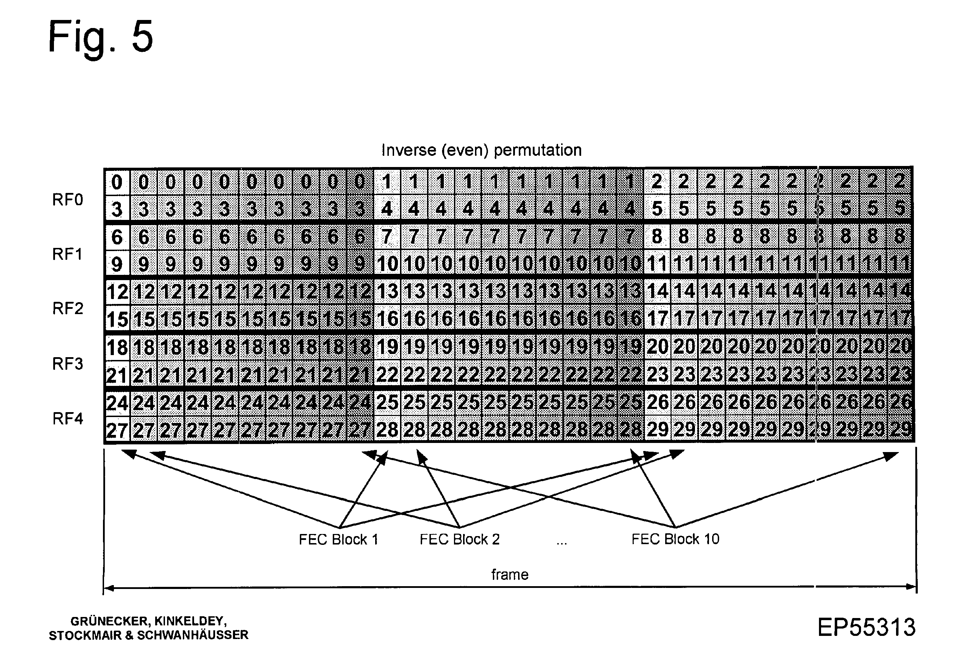

Figure 5 is a schematic drawing illustrating the interleaving scheme for of even-frame transmit data according to the example of Fig. 4. Specifically, Fig. 5 indicates the inverse permutation of the permutation indicated in Fig. 4.

Form Figs. 4 and 5, it can be clearly seen that each FEC block is evenly distributed over all RF channels, both for odd and even frames. The only shortcoming, however, is that after the direct permutation (Fig. 4), the words belonging to the same FEC block form contiguous blocks, which limits the diversity within the RF channel (intra RF diversity). The inverse permutation does not have this problem, as the output words sequentially cycle through all FEC blocks.

According to the second embodiment of this invention, this issue can be fixed by introducing an additional permutation of the columns of the direct permutation matrix. The resulting permutation matrix is absolutely identical for the direct and the inverse permutations. This means that the resulting permutation is its own inverse. The fact that a permutation p(i) is its own inverse can be mathematically expressed as $p(p(i))=i$, where $i$ is the word index within the interleaving block.

Any permutation of the columns does not affect the distribution of the FEC blocks over the RF channels, but merely changes the indices of the words within an FEC block.

The proposed permutation of the columns can be mathematically expressed as:

$$p(k) = k \bmod N_{COL} + \mathrm{floor}(k/N_{COL}) \qquad (3)$$

where $k$ is the column index between 0 and $N_{COL}$-1, mod is the modulo operator, and floor returns the next lower integer.

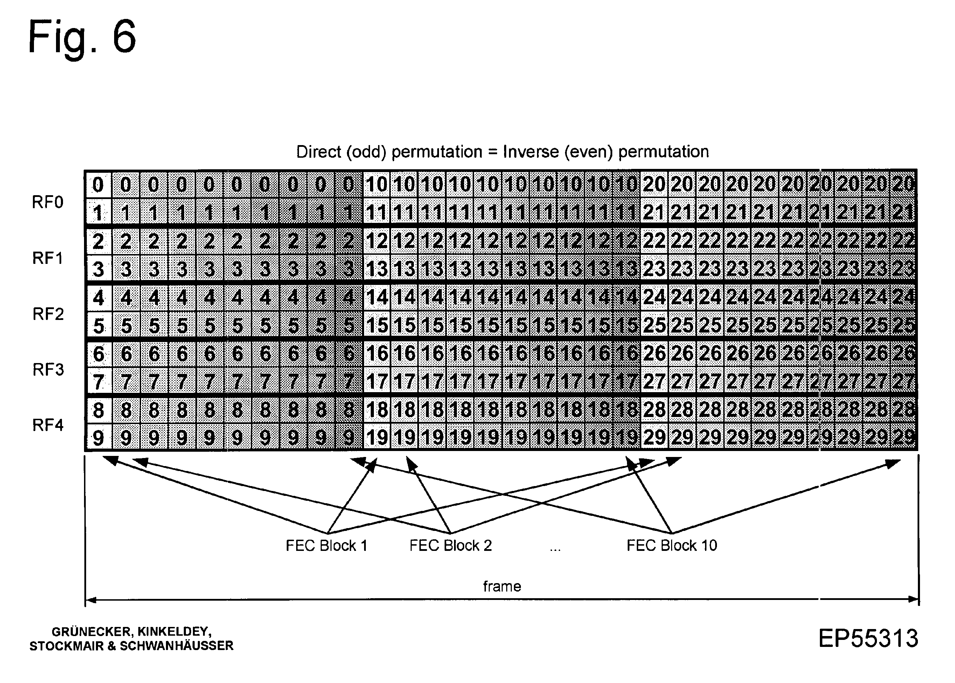

Figure 6 is a schematic drawing illustrating an exemplary interleaving scheme for odd-frame and even-frame transmit data according to the second embodiment of the present invention. This example is similar to that of Fig. 4, except that the FEC data words are written to columns by taking the permutation of Eq. (3) into account. The RF allocation and read-out is the same as in Fig. 4.

The resulting interleaving pattern ensures that the intra RF diversity is also maximized because the words from each FEC block are uniformly spread/interleaved over the whole data block sent over an RF channel.

It is the particular advantage of this embodiment that the permutation indicated in Fig. 6 is self-inverse, i.e., that odd and even frames may be interleaved according to the same permutation. This property may greatly simplify any hardware and software implementation.

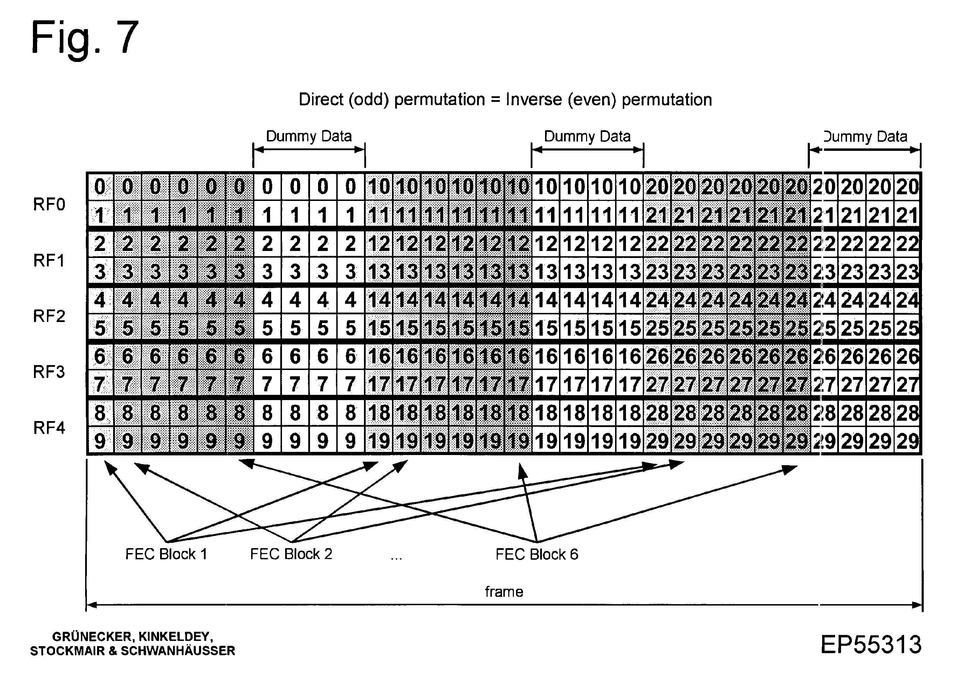

The present invention is also very suitable for variable data rates. If the actual number of FEC blocks is smaller than the maximum value $N_{FEC}$, the remaining capacity is conceptually filled with dummy words. An example is shown in Figure 7, which is a schematic drawing illustrating an exemplary interleaving scheme for odd-frame and even-frame transmit data according to the third embodiment of the present invention. In this example, only 6 FEC blocks are sent in the frame. The remaining space of 4 FEC blocks is conceptually filled with dummy words. Apart from the padding with dummy data, the example of Fig. 7 is identical to that of Fig. 6.

As can be seen from Fig. 7, the inventive interleaving scheme has the additional advantage that the position of the dummy words after interleaving is easy to be determined. If for an output word index i we have that mod(i,$N_{FEC}$) is larger than or equal the actual number of FEC blocks, that word is dummy. Here, mod is the modulo operator. It is important to know if a word is dummy because dummy words are not transmitted and must be discarded after interleaving in the transmitter. In the receiver, they must be reintroduced at the appropriate position.

The easiness of determining the positions of the dummy words greatly simplifies the hardware implementation of both the interleaver and the deinterleaver.

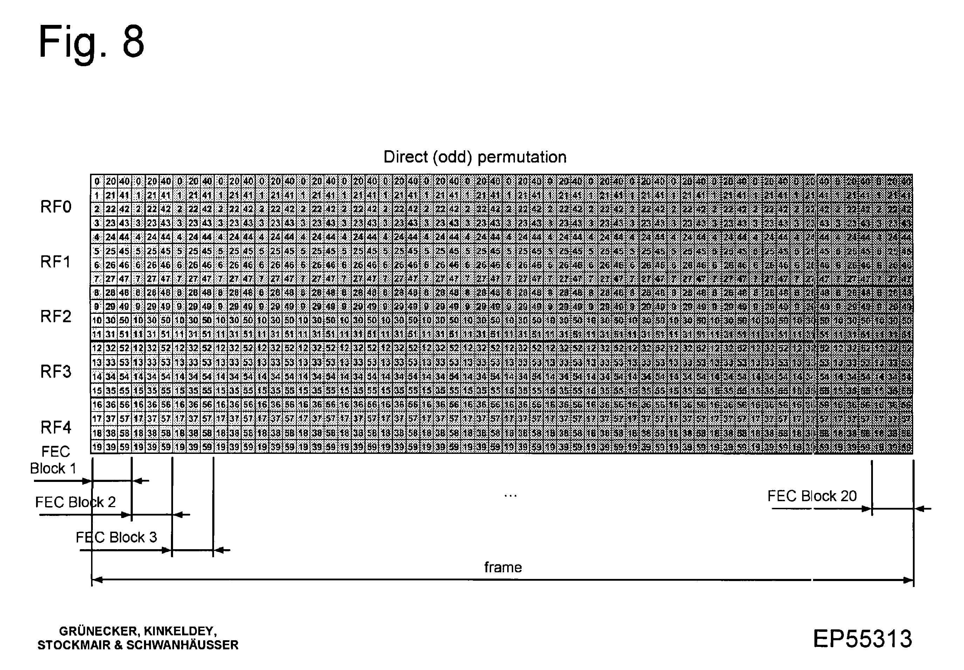

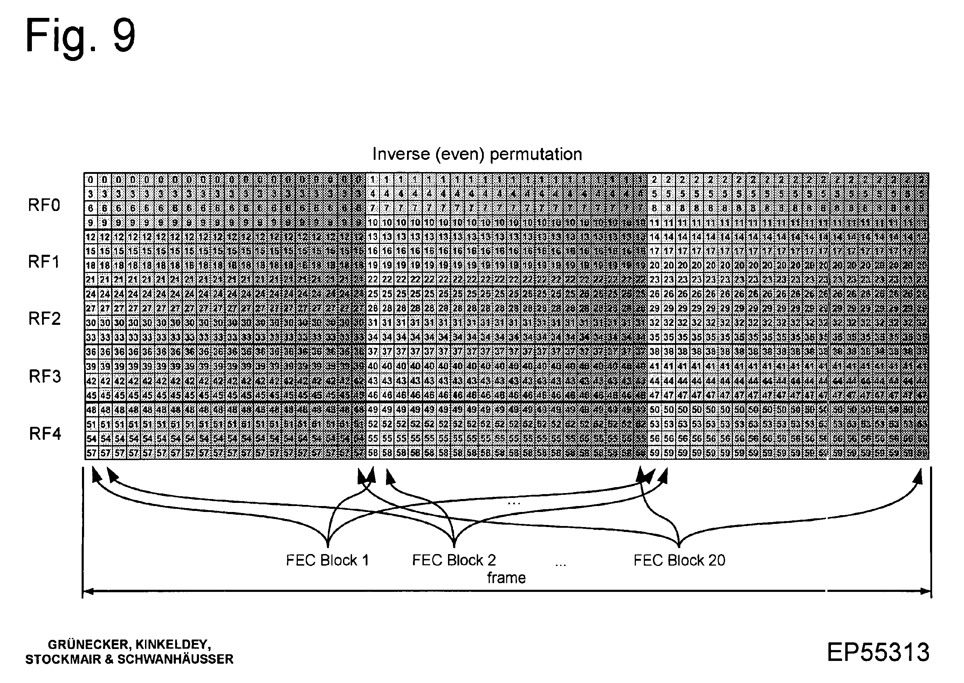

Figures 8 and 9 provide another example of the interleaving scheme for odd-frame transmit data and even-frame transmit data according to the first embodiment of the present invention, respectively. In these examples, a frame is made up of a total of 20 FEC blocks ($N_{FEC}$=20) with 60 words each ($S_{FEC}$=60). As before, the frame data is allocated to five RF channels ($N_{RF}$=5, RF0,...,RF4). The words of the FEC blocks are consecutively written (top to bottom, left to right) to the columns of a matrix having $N_{COL}=S_{FEC}$=60 columns and $N_{ROW}=N_{FEC}$=20 rows. In this matrix, each $n=N_{FEC}/N_{RF}$=4 adjacent rows are allocated to one of the RF channels RF0, RF1, ..., RF4.

It is to be noted that the parameter values employed in this example do also satisfy the above mentioned constraints. Specifically, the number of words per FEC block $S_{FEC}$ is an multiple of the number of RF channels $N_{RF}$. Further, the maximum number of FEC blocks per frame $N_{FEC}$ is an integer multiple of the number of RF channels $N_{RF}$ and the number of words per FEC block $S_{FEC}$ is an integer multiple of the maximum number of FEC blocks per frame $N_{FEC}$.

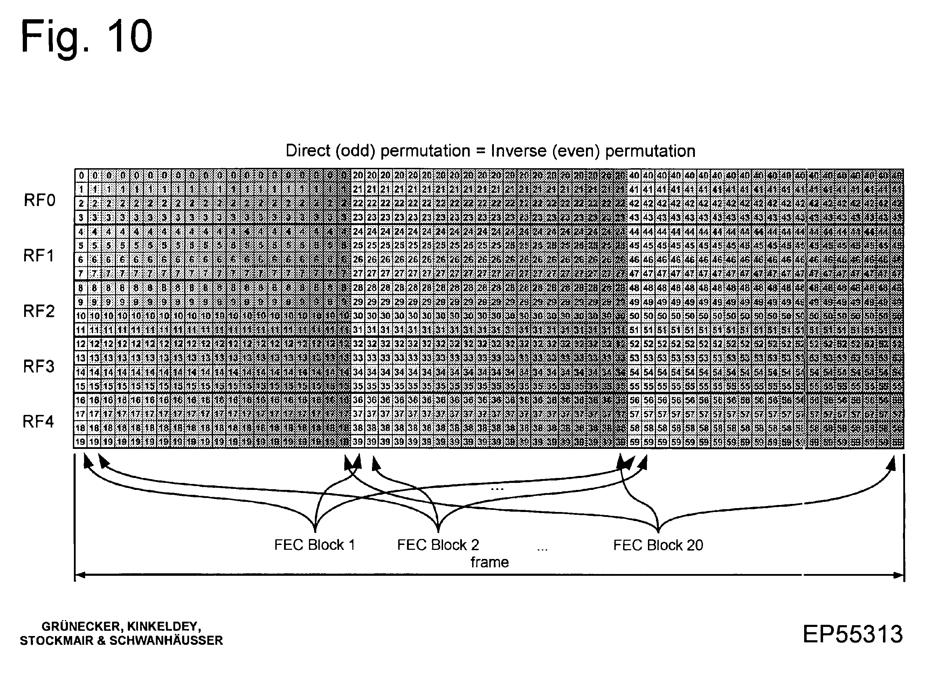

Figure 10 is a further example illustrating an exemplary interleaving scheme for odd-frame and even-frame transmit data according to the second embodiment of the present invention. This example is similar to Fig. 6, except that the parameter values of the example shown in Figs. 8 and 9 are employed.

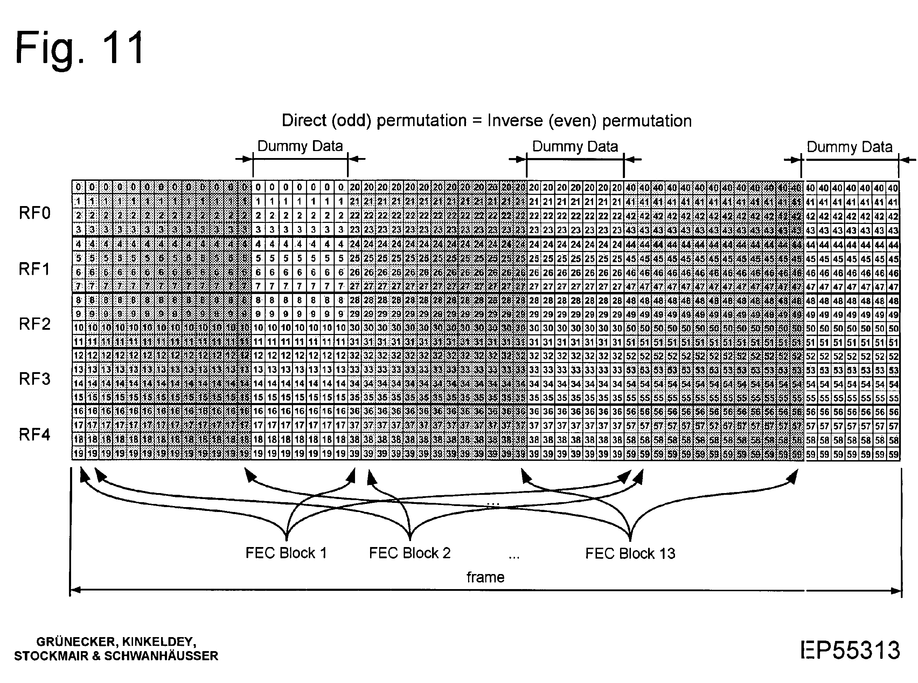

Figure 11 is a further example illustrating an exemplary interleaving scheme for odd-frame and even-frame transmit data according to the third embodiment of the present invention. This example is similar to Fig. 7, except that the parameter values of the example shown in Figs. 8 and 9 are employed.

As it is apparent from the above description, the permutation scheme of each embodiment is fully defined by the number of RF channels $N_{RF}$, the number of words per FEC block $S_{FEC}$, and the maximum number of FEC blocks per frame $N_{FEC}$, all of which are static parameters that do not change from frame to frame. In order to deinterleave the received data, the receiver thus merely needs to know the above static parameters and the actual number of FEC blocks in the current frame. In contrast to the static parameters, the actual number of FEC blocks in the current frame is a dynamic parameter, which is changing for every frame.

In the above embodiments, interleaving has been applied to the entire transmit frame. In some cases, however, it may be desirable to divide an OFDM frame into a number of sub-frames (1,2, 3, etc.) and perform interleaving independently over each sub-frame. This has the advantage of reducing the memory requirements. The condition is that the number of sub-frames be a divisor of the selected maximum number of FEC blocks per frame. In this case, everything mentioned about a full frame applies to sub-frames. So instead of defining a maximum number of FEC blocks per frame we define the same for the sub-frame. For example, with 2 RF channels we can divide the frame into 2 or 3 sub-frames. With only one RF channel, the frame could be divided into 2, 3, 4, etc. sub-frames. The exact number of sub-frame is not important.

Summarizing, the present invention relates to interleaving of transmit data in a frame-based communication system employing a plurality of frequency channels, wherein odd and even frames are interleaved according to a predefined permutation and its inverse permutation, respectively. The present invention provides specific permutations guaranteeing that diversity across the frequency channels is maximum both for odd and even frames. To this end, certain constraints to the number of words per forward error correction block, the maximum number of forward error correction blocks per frame, and the number of frequency channels are identified. According to a particularly advantageous embodiment of the present invention, the permutation is self-inverse, so that odd and even frames are interleaved by a common interleaving scheme.

## Claims

1. A method for data transmission in a frame-based communication system employing a plurality of frequency channels, each frame of transmit data consisting of a plurality of error correction blocks, each error correction block consisting of a plurality of words, each word of a frame being allocated to one of the plurality of frequency channels for transmission, said method comprising the step of interleaving the transmit data
by applying a predefined permutation to the words of odd frames and
by applying the inverse of the predefined permutation to the words of even frames,
**characterized in that**
said predefined permutation and its inverse permutation are distributing the words of each error correction block of odd and even frames, respectively, equally over the frequency channels.

2. A method according to claim 1, wherein each frequency channel transmits the same number of words of each error correction block of a frame.

3. A method according to claim 1 or 2, wherein the number of words of a certain error correction block allocated to a frequency channel is equal for all frequency channels.

4. A method according to any of claims 1 to 3, wherein the number of words of an error correction block allocated to a certain frequency channel is equal for all error correction blocks.

5. A method according to any of claims 1 to 4, wherein the predefined permutation and its inverse permutation are distributing the words of each error correction block of odd and even frames, respectively, evenly over the frame.

**6.** A method according to any of claims 1 to 5, wherein the number of words in an error correction block is an integer multiple of the number of frequency channels.

**7.** A method according to claim 6, wherein a maximum number of error correction blocks per frame is an integer multiple of the number of frequency channels.

**8.** A method according to claim 7, wherein the number of words in an error correction block is an integer multiple of the maximum number of error correction blocks per frame.

**9.** A method according to claim 8, wherein each frame consists of a plurality of columns, each column consisting of a predefined number of consecutive words of an error correction block, said predefined number being equal to the the maximum number of error correction blocks per frame.

**10.** A method according to claim 9, wherein each column of a frame consists of a plurality of clusters, each cluster consisting of a predefined number of consecutive words of an error correction block, said predefined number being equal to the ratio of the maximum number of error correction blocks per frame and the number of frequency channels, each cluster of said plurality of clusters being allocated to a distinct frequency channel of the plurality of frequency channels.

**11.** A method according to claim 10, wherein the clusters of each frame are allocated to the plurality of frequency channels in a cyclic manner.

**12.** A method according to any of claims 1 to 11, wherein the predefined permutation and inverse permutation are identical.

**13.** A computer program product comprising a computer readable medium having computer readable program code embodied thereon, the program code being adapted to carry out all steps of any of claims 1 to 12.

**14.** A frame-based communication system employing a plurality of frequency channels, each frame of transmit data consisting of a plurality of error correction blocks, each error correction block consisting of a plurality of words, each word of a frame being allocated to one of the plurality of frequency channels for transmission, said communication system comprising
an interleaver for interleaving the transmit data by applying a predefined permutation to the words of odd frames and by applying the inverse of the predefined permutation to the words of even frames,
**characterized in that**
said predefined permutation and its inverse permutation are distributing the words of each error correction block of odd and even frames, respectively, equally over the frequency channels.

**15.** A communication system according to claim 14, wherein each frequency channel transmits the same number of words of each error correction block of a frame.

**16.** A communication system according to claim 14 or 15, wherein the number of words of a certain error correction block allocated to a frequency channel is equal for all frequency channels.

**17.** A communication system according to any of claims 14 to 16, wherein the number of words of an error correction block allocated to a certain frequency channel is equal for all error correction blocks.

**18.** A communication system according to any of claims 14 to 17, wherein the predefined permutation and its inverse permutation are distributing the words of each error correction block of odd and even frames, respectively, evenly over the frame.

**19.** A communication system according to any of claims 14 to 18, wherein the number of words in an error correction block is an integer multiple of the number of frequency channels.

**20.** A communication system according to claim 19, wherein a maximum number of error correction blocks per frame is an integer multiple of the number of frequency channels.

**21.** A communication system according to claim 20, wherein the number of words in an error correction block is an integer multiple of the maximum number of error correction blocks per frame.

22. A communication system according to claim 21, wherein each frame consists of a plurality of columns, each column consisting of a predefined number of consecutive words of an error correction block, said predefined number being equal to the the maximum number of error correction blocks per frame.

23. A communication system according to claim 22, wherein each column of a frame consists of a plurality of clusters, each cluster consisting of a predefined number of consecutive words of an error correction block, said predefined number being equal to the ratio of the maximum number of error correction blocks per frame and the number of frequency channels, each cluster of said plurality of clusters being allocated to a distinct frequency channel of the plurality of frequency channels.

24. A communication system according to claim 23, wherein the clusters of each frame are allocated to the plurality of frequency channels in a cyclic manner.

25. A communication system according to any of claims 14 to 24, wherein the predefined permutation and inverse permutation are identical.

EP 2 063 538 A1

# Fig. 2B

Inverse (even) permutation

frame

| | | | | | | | | | | | | | | | | | | | | | | | |
|---|---|---|---|---|---|---|---|---|---|---|---|---|---|---|---|---|---|---|---|---|---|---|---|
| RF5 | 7 | 11 | 15 | 19 | 0 | 4 | 8 | 12 | 16 | 21 | 8 | 4 | 0 | 20 | 5 | 9 | 13 | 17 | 21 | 2 | 6 | 10 | 14 | 18 | 22 | 3 | 7 | 11 | 15 | 19 | 23 |
| RF4 | 10 | 14 | 19 | 23 | 3 | 7 | 11 | 15 | 20 | 0 | 4 | 8 | 12 | 16 | 21 | 1 | 5 | 9 | 13 | 17 | 22 | 2 | 6 | 10 | 18 | 14 | 18 | 23 | 3 |
| RF3 | 14 | 18 | 22 | 2 | 6 | 10 | 15 | 19 | 23 | 3 | 7 | 11 | 16 | 20 | 0 | 4 | 8 | 12 | 17 | 21 | 1 | 5 | 9 | 13 | 18 | 22 | 2 | 6 |
| RF2 | 17 | 21 | 5 | 9 | 13 | 17 | 21 | 1 | 5 | 9 | 13 | 8 | 4 | 0 | 20 | 16 | 12 | 7 | 3 | 23 | 19 | 15 | 11 | 6 | 2 | 22 | 18 | 14 | 10 |
| RF1 | 20 | 0 | 5 | 9 | 13 | 17 | 21 | 1 | 6 | 9 | 10 | 14 | 18 | 22 | 2 | 7 | 11 | 15 | 19 | 23 | 3 | 8 | 12 | 16 | 20 | 0 | 4 | 9 | 13 |
| RF0 | 0 | 4 | 8 | 12 | 16 | 20 | 1 | 5 | 9 | 13 | 17 | 21 | 2 | 6 | 10 | 14 | 18 | 22 | 3 | 7 | 11 | 15 | 19 | 23 | 4 | 8 | 12 | 16 |

# Fig. 2A

Direct (odd) permutation

frame

| | FEC Block 1 | | | | FEC Block 2 | | | | FEC Block 3 | | | | FEC Block 4 | | | | FEC Block 5 | | | | FEC Block 6 | | | | FEC Block 7 | | | |
|---|---|---|---|---|---|---|---|---|---|---|---|---|---|---|---|---|---|---|---|---|---|---|---|---|---|---|---|---|
| RF5 | 5 | 11 | 17 | 23 | 5 | 11 | 17 | 23 | 5 | 11 | 17 | 23 | 5 | 11 | 17 | 23 | 5 | 11 | 17 | 23 | 5 | 11 | 17 | 23 | 5 | 11 | 17 | 23 |
| RF4 | 4 | 10 | 16 | 22 | 4 | 10 | 16 | 22 | 4 | 10 | 16 | 22 | 4 | 10 | 16 | 22 | 4 | 10 | 16 | 22 | 4 | 10 | 16 | 22 | 4 | 10 | 16 | 22 |
| RF3 | 3 | 9 | 15 | 21 | 3 | 9 | 15 | 21 | 3 | 9 | 15 | 21 | 3 | 9 | 15 | 21 | 3 | 9 | 15 | 21 | 3 | 9 | 15 | 21 | 3 | 9 | 15 | 21 |
| RF2 | 2 | 8 | 14 | 20 | 2 | 8 | 14 | 20 | 2 | 8 | 14 | 20 | 2 | 8 | 14 | 20 | 2 | 8 | 14 | 20 | 2 | 8 | 14 | 20 | 2 | 8 | 14 | 20 |
| RF1 | 1 | 7 | 13 | 19 | 1 | 7 | 13 | 19 | 1 | 7 | 13 | 19 | 1 | 7 | 13 | 19 | 1 | 7 | 13 | 19 | 1 | 7 | 13 | 19 | 1 | 7 | 13 | 19 |
| RF0 | 0 | 6 | 12 | 18 | 0 | 6 | 12 | 18 | 0 | 6 | 12 | 18 | 0 | 6 | 12 | 18 | 0 | 6 | 12 | 18 | 0 | 6 | 12 | 18 | 0 | 6 | 12 | 18 |

# Fig. 3A

Direct (odd) permutation

| | | | | | | | | | | | | | | | | | | | | | | | |
|---|---|---|---|---|---|---|---|---|---|---|---|---|---|---|---|---|---|---|---|---|---|---|---|
| RF0 | 0 | 6 | 12 | 18 | 0 | 6 | 12 | 18 | 0 | 6 | 12 | 18 | 0 | 6 | 12 | 18 | 0 | 6 | 12 | 18 | 0 | 6 | 12 | 18 |
| RF1 | 1 | 7 | 13 | 19 | 1 | 7 | 13 | 19 | 1 | 7 | 13 | 19 | 1 | 7 | 13 | 19 | 1 | 7 | 13 | 19 | 1 | 7 | 13 | 19 |
| RF2 | 2 | 8 | 14 | 20 | 2 | 8 | 14 | 20 | 2 | 8 | 14 | 20 | 2 | 8 | 14 | 20 | 2 | 8 | 14 | 20 | 2 | 8 | 14 | 20 |
| RF3 | 3 | 9 | 15 | 21 | 3 | 9 | 15 | 21 | 3 | 9 | 15 | 21 | 3 | 9 | 15 | 21 | 3 | 9 | 15 | 21 | 3 | 9 | 15 | 21 |
| RF4 | 4 | 10 | 16 | 22 | 4 | 10 | 16 | 22 | 4 | 10 | 16 | 22 | 4 | 10 | 16 | 22 | 4 | 10 | 16 | 22 | 4 | 10 | 16 | 22 |
| RF5 | 5 | 11 | 17 | 23 | 5 | 11 | 17 | 23 | 5 | 11 | 17 | 23 | 5 | 11 | 17 | 23 | 5 | 11 | 17 | 23 | 5 | 11 | 17 | 23 |

FEC Block 1 | FEC Block 2 | FEC Block 3 | FEC Block 4 | FEC Block 5 | Dummy Data

frame

# Fig. 3B

Inverse (even) permutation

| | | | | | | | | | | | | | | | | | | | | | | | | |
|---|---|---|---|---|---|---|---|---|---|---|---|---|---|---|---|---|---|---|---|---|---|---|---|---|
| RF0 | 0 | 4 | 8 | 12 | 16 | 20 | 1 | 5 | 9 | 13 | 17 | 21 | 2 | 6 | 10 | 14 | 18 | 22 | 3 | 7 | 11 | 15 | 19 | 23 | 4 | 8 | 12 | 16 |
| RF1 | 20 | 0 | 5 | 9 | 13 | 17 | 21 | 1 | 6 | 10 | 14 | 18 | 22 | 2 | 7 | 11 | 15 | 19 | 23 | 3 | 8 | 12 | 16 | 20 | 0 | 4 | 9 | 13 |
| RF2 | 17 | 21 | 1 | 5 | 10 | 14 | 18 | 22 | 2 | 6 | 11 | 15 | 19 | 23 | 3 | 7 | 12 | 16 | 20 | 0 | 4 | 8 | 13 | 17 | 21 | 1 | 5 | 9 |
| RF3 | 14 | 18 | 22 | 2 | 6 | 10 | 15 | 19 | 23 | 3 | 7 | 11 | 16 | 20 | 0 | 4 | 8 | 12 | 17 | 21 | 1 | 5 | 9 | 13 | 18 | 22 | 2 | 6 |
| RF4 | 10 | 14 | 19 | 23 | 3 | 7 | 11 | 15 | 20 | 0 | 4 | 8 | 12 | 16 | 21 | 1 | 5 | 9 | 13 | 17 | 22 | 2 | 6 | 10 | 14 | 18 | 23 | 3 |
| RF5 | 7 | 11 | 15 | 19 | 0 | 4 | 8 | 12 | 16 | 20 | 1 | 5 | 9 | 13 | 17 | 21 | 2 | 6 | 10 | 14 | 18 | 22 | 3 | 7 | 11 | 15 | 19 | 23 |

frame

GRÜNECKER, KINKELDEY,
STOCKMAIR & SCHWANHÄUSSER

EP55313

# Fig. 4

Direct (odd) permutation

RF0
RF1
RF2
RF3
RF4

| FEC Block 1 | FEC Block 2 | FEC Block 3 | ... | FEC Block 10 |

frame

# Fig. 5

EP 2 063 538 A1

Inverse (even) permutation

| RF0 | 0 | 0 | 0 | 0 | 0 | 0 | 0 | 0 | 0 | 0 | 1 | 1 | 1 | 1 | 1 | 1 | 1 | 1 | 1 | 1 | 2 | 2 | 2 | 2 | 2 | 2 | 2 | 2 | 2 | 2 |
|---|---|---|---|---|---|---|---|---|---|---|---|---|---|---|---|---|---|---|---|---|---|---|---|---|---|---|---|---|---|---|
| | 3 | 3 | 3 | 3 | 3 | 3 | 3 | 3 | 3 | 3 | 4 | 4 | 4 | 4 | 4 | 4 | 4 | 4 | 4 | 4 | 5 | 5 | 5 | 5 | 5 | 5 | 5 | 5 | 5 | 5 |
| RF1 | 6 | 6 | 6 | 6 | 6 | 6 | 6 | 6 | 6 | 6 | 7 | 7 | 7 | 7 | 7 | 7 | 7 | 7 | 7 | 7 | 8 | 8 | 8 | 8 | 8 | 8 | 8 | 8 | 8 | 8 |
| | 9 | 9 | 9 | 9 | 9 | 9 | 9 | 9 | 9 | 9 | 10 | 10 | 10 | 10 | 10 | 10 | 10 | 10 | 10 | 10 | 11 | 11 | 11 | 11 | 11 | 11 | 11 | 11 | 11 | 11 |
| RF2 | 12 | 12 | 12 | 12 | 12 | 12 | 12 | 12 | 12 | 12 | 13 | 13 | 13 | 13 | 13 | 13 | 13 | 13 | 13 | 13 | 14 | 14 | 14 | 14 | 14 | 14 | 14 | 14 | 14 | 14 |
| | 15 | 15 | 15 | 15 | 15 | 15 | 15 | 15 | 15 | 15 | 16 | 16 | 16 | 16 | 16 | 16 | 16 | 16 | 16 | 16 | 17 | 17 | 17 | 17 | 17 | 17 | 17 | 17 | 17 | 17 |
| RF3 | 18 | 18 | 18 | 18 | 18 | 18 | 18 | 18 | 18 | 18 | 19 | 19 | 19 | 19 | 19 | 19 | 19 | 19 | 19 | 19 | 20 | 20 | 20 | 20 | 20 | 20 | 20 | 20 | 20 | 20 |
| | 21 | 21 | 21 | 21 | 21 | 21 | 21 | 21 | 21 | 21 | 22 | 22 | 22 | 22 | 22 | 22 | 22 | 22 | 22 | 22 | 23 | 23 | 23 | 23 | 23 | 23 | 23 | 23 | 23 | 23 |
| RF4 | 24 | 24 | 24 | 24 | 24 | 24 | 24 | 24 | 24 | 24 | 25 | 25 | 25 | 25 | 25 | 25 | 25 | 25 | 25 | 25 | 26 | 26 | 26 | 26 | 26 | 26 | 26 | 26 | 26 | 26 |
| | 27 | 27 | 27 | 27 | 27 | 27 | 27 | 27 | 27 | 27 | 28 | 28 | 28 | 28 | 28 | 28 | 28 | 28 | 28 | 28 | 29 | 29 | 29 | 29 | 29 | 29 | 29 | 29 | 29 | 29 |

FEC Block 1     FEC Block 2     ...     FEC Block 10

frame

GRÜNECKER, KINKELDEY,
STOCKMAIR & SCHWANHÄUSSER

EP55313

# Fig. 6

Direct (odd) permutation = Inverse (even) permutation

GRÜNECKER, KINKELDEY,
STOCKMAIR & SCHWANHÄUSSER

EP55313

EP 2 063 538 A1

# Fig. 7

Direct (odd) permutation = Inverse (even) permutation

Dummy Data       Dummy Data       Dummy Data

RF0
RF1
RF2
RF3
RF4

FEC Block 1     FEC Block 2     ...     FEC Block 6

frame

GRÜNECKER, KINKELDEY,
STOCKMAIR & SCHWANHÄUSSER

EP55313

# Fig. 8

Direct (odd) permutation

RF0
RF1
RF2
RF3
RF4

FEC Block 1
FEC Block 2
FEC Block 3

FEC Block 20

frame

...

# Fig. 9

# Fig. 10

EP 2 063 538 A1

Direct (odd) permutation = Inverse (even) permutation

RF0

RF1

RF2

RF3

RF4

FEC Block 1    FEC Block 2    ...    FEC Block 20

frame

EP55313

# Fig. 11

Direct (odd) permutation = Inverse (even) permutation

FEC Block 1    FEC Block 2    ...    FEC Block 13

frame

GRÜNECKER, KINKELDEY,
STOCKMAIR & SCHWANHÄUSSER

EP55313

**European Patent Office**

**EUROPEAN SEARCH REPORT**

Application Number

EP 07 02 2488

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,X | EP 0 754 320 A (PHILIPS ELECTRONICS NV [NL]; PHILIPS NORDEN AB [SE] KONINKL PHILIPS EL) 22 January 1997 (1997-01-22)<br>* paragraphs [0016] - [0018], [0L35] *<br>* paragraphs [0058] - [0061] *<br>----- | 1-5, 14-18 | INV.<br>H03M13/27 |
| X | US 2006/071843 A1 (CHAMPION MARK [US]) 6 April 2006 (2006-04-06)<br>* paragraphs [0014], [0015], [0040] *<br>* paragraphs [0045], [0054] - [0060] *<br>----- | 1-5, 14-18 | |
| A | EP 0 673 131 A (TOKYO SHIBAURA ELECTRIC CO [JP]) 20 September 1995 (1995-09-20)<br>* the whole document *<br>----- | 1-25 | |

| | TECHNICAL FIELDS SEARCHED (IPC) |
|---|---|
| | H03M<br>H04L<br>H04N<br>G11B |

The present search report has been drawn up for all claims

| Place of search | Date of completion of the search | Examiner |
|---|---|---|
| The Hague | 13 August 2008 | Anghel, Paul |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

.............................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 02 2488

This annex lists the patent family members relating to the patent documents cited in the above-mentioned European search report.
The members are as contained in the European Patent Office EDP file on
The European Patent Office is in no way liable for these particulars which are merely given for the purpose of information.

13-08-2008

| Patent document cited in search report | | Publication date | Patent family member(s) | | Publication date |
|---|---|---|---|---|---|
| EP 0754320 | A | 22-01-1997 | NONE | | |
| US 2006071843 | A1 | 06-04-2006 | US 2006158367 | A1 | 20-07-2006 |
| EP 0673131 | A | 20-09-1995 | CA 2144663 | A1 | 16-09-1995 |
| | | | JP 3139909 | B2 | 05-03-2001 |
| | | | JP 7254915 | A | 03-10-1995 |
| | | | US 5646935 | A | 08-07-1997 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5799033 A